# EUROPÄISCHE PATENTSCHRIFT

(11) **EP 0 269 818 B1**
(45) Veröffentlichungstag und Bekanntmachung des Hinweises auf die Patenterteilung: **10.03.1993**
(21) Anmeldenummer: 87115176.7
(22) Anmeldetag: 16.10.1987
(51) Int. Cl.: G05B 9/03, H03K 19/003

(54) **Digitale 2 von 3-Auswahl- und Ausgabeschaltung**
Digital circuit for selecting two out of three channels and output circuit
Circuit digital de sortie et de sélection de deux voies parmi trois

(30) Priorität: 03.11.1986 DE 3637238
(43) Veröffentlichungstag der Anmeldung: 08.06.1988
(73) Patentinhaber: SIEMENS AKTIENGESELLSCHAFT, 80333 München (DE)
(72) Erfinder: Gäbel, Lutz, D-3341 Gross Denkte (DE)

(56) Entgegenhaltungen:
- EP-A- 0 073 602
- GB-A- 2 128 007
- US-A- 4 176 401
- ELEKTRONIK, Band 26, Nr. 12, 1977, Teil 2., Seiten 61-65; K. MEYER: "Sicherheitssysteme für elektronisch gesteuerte Anlagen"
- AEG Telefunken Fachbuch 1970, S-208 - 209.
- M. Bleicher, Halbleiter-Optoelektronik, A. Hüthig Verlag 1986, S. 175-177.

## Beschreibung

Die Erfindung bezieht sich auf eine digitale 2 von 3-Auswahl-und Ausgabeschaltung mit sechs Optokopplern, bei welcher drei getrennte Datenkanäle unter zyklischer Vertauschung jeweils paarig drei UND-Gliedern zugeführt sind, denen eine gemeinsame ODER-Verknüpfung folgt als Ausgabeglied.

Derartige Schaltungen geben jeweils das gleiche Ergebnis von mindestens zwei von drei Datenkanälen bzw. Datenverarbeitungsanlagen aus. Ein 1-Signal entsteht somit am Ausgang der Schaltung immer dann, wenn mindestens zwei der drei Datenkanäle ein 1-Signal liefern. Es kann also ein Datenkanal ausfallen und damit ein von den übrigen Datenkanälen abweichendes Ergebnis anbieten, ohne daß das Ausgangs-1-Signal deswegen gesperrt würde. Führen dagegen mindestens zwei Datenkanäle 0-Signal, so führt auch der Ausgang der Schaltung 0-Signal. Derartige Auswahl- bzw. Ausgabeschaltungen sind bekannt - Edgar Dombrowski: Einführung in die Zuverlässigkeit elektronischer Geräte und Systeme, AEG-Telefunken-Fachbuch 1970, Seiten 208/209 - und finden allgemein Anwendung in Sicherheitsschaltwerken, z.B. in der Eisenbahnsignaltechnik. Hierbei werden entsprechend den hohen Sicherheitserfordernissen, aber auch im Hinblick auf eine gute Verfügbarkeit wesentliche Teile von Datenverarbeitungs- und Steuerungsanlagen verdreifacht. In allen drei der so gebildeten Datenkanäle werden dieselben Informationen verarbeitet. Die eingangs geschilderte digitale 2 von 3-Auswahl-und Ausgabeschaltung dient dabei der Zusammenfassung der drei Datenkanäle.

Aus der EP-A2 0 073 602 ist eine digitale 2 von 3-Auswahl- und Ausgabeschaltung mit insgesamt sechs Optokopplern bekannt. Mindestens jeweils zwei dieser Optokoppler sind durch an unterschiedlichen Verarbeitungskanälen anliegende Eingangssignale zu aktivieren, damit die Schaltung ein Ausgangssignal der gleichen Wertigkeit führt. Hierzu sind die Schalttransistoren eines Teils der Optokoppler mit bestimmten Leuchtdioden anderer Optokoppler in Reihe geschaltet; an dem Schalttransistor dieser Optokoppler sind dann die Ausgangssignale der Schaltung abgreifbar. Damit sind die Ausgangssignale der Schaltung allein abhängig vom Betriebverhalten der Schalttransistoren. Wird einer dieser Schalttransistoren zur Unzeit hoch- oder niederohmig, beispielsweise infolge eines Bauteildefektes oder infolge einer Leitungsberührung/Leitungsauftrennung, so erscheint am Ausgang der Schaltung mit großer Wahrscheinlichkeit ein fehlerhaftes Signal, das im Falle eines 1-Signals prozeßfreigebend und damit gefährlich wäre.

Der Erfindung liegt die Aufgabe zugrunde, die bekannte digitale 2 von 3-Auswahl- und Ausgabeschaltung so auszubilden, daß trotz der vorzunehmenden logischen Verknüpfungen keine unerwünschten Rückwirkungen auf die anderen beteiligten Schaltglieder eintreten, wobei insbesondere sichergestellt sein soll, daß durch einen beliebigen Defekt innerhalb der Schaltung am Ausgang derselben kein fehlerhaftes 1-Signal auftreten soll.

Erfindungsgemäß wird die Aufgabe dadurch gelöst, daß die Lichtsender jeweils zweier Optokoppler in Reihe an je einen der Datenkanäle angeschlossen sind und daß jeweils zwei Lichtempfänger von Optokopplern, die sendeseitig verschiedenen Datenkanälen zugeordnet sind, eine Reihenschaltung bilden und alle diese Reihenschaltungen auf die ODER-Verknüpfung geführt sind.

Der besondere Vorteil dieser erfindungsgemäßen Ausbildung liegt im geringen Aufwand, mit dem die gestellte Aufgabe gelöst wird.

Eine bevorzugte vorteilhafte Ausbildung der Erfindung sieht vor, daß die drei aus in Reihe geschalteten Lichtempfängern gebildeten Reihenschaltungen in einem "Verdrahteten ODER" zusammengefaßt sind und ein Ausgaberelais speisen. Ein Ausführungsbeispiel der Erfindung ist in der Zeichung dargestellt und wird nachfolgend näher erläutert.

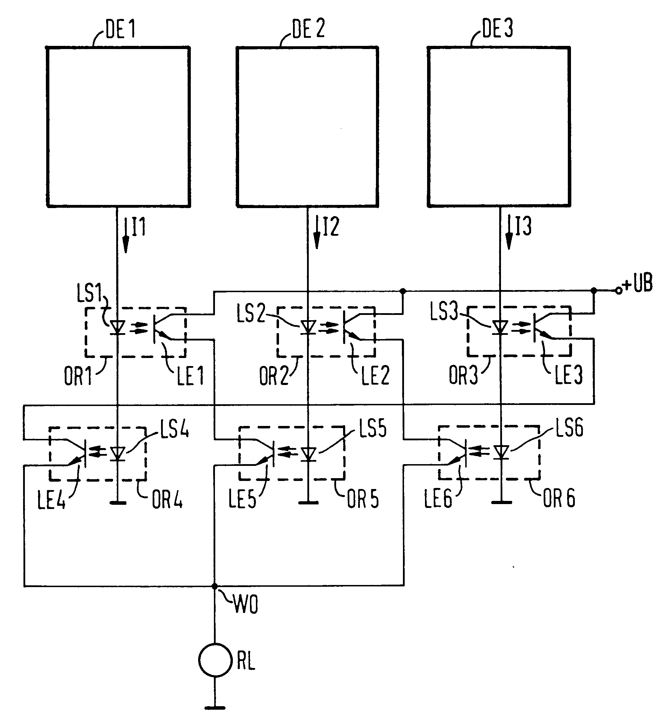

Die Zeichnung zeigt nähere Einzelheiten einer digitalen 2 von 3-Auswahl- und Ausgabeschaltung für eine Information, die aus Sicherheitsgründen nicht nur über einen Datenkanal, sondern über drei Datenkanäle DE1, DE2 und DE3 als Information I1 bzw. I2 und I3 zur Verfügung gestellt wird. Es kommen sechs Optokoppler OR1, OR2 bis OR6 zur Anwendung. Jeweils die Lichtsender zweier Optokoppler, z.B. die Lichtsender LS1 und LS4 der Optokoppler OR1 und OR4 sind in Reihe geschaltet und an den Ausgang des Datenkanals DE1 angeschlossen. Entsprechendes gilt für die Lichtsender LS2 und LS5 bzw. LS3 und LS6 der Optokoppler OR2 und OR5 bzw. OR3 und OR6 im Hinblick auf den Ausgang des Datenkanals DE2 bzw. DE3 sinngemäß.
Zur Bildung einer ersten 2 von 3-Funktion ist der Lichtempfänger LE1 des dem Datenkanal DE1 zugeordneten Optokopplers OR1 in Reihe geschaltet mit dem Lichtempfänger LE5 des dem anderen Datenkanal DE2 zugeordneten Optokopplers OR5. Die so gebildete Reihenschaltung (UND-Verknüpfung) wird aus (+) UB mit Energie versorgt und steuert ggf. ein Ausgaberelais RL. Dieses wird stets angeschaltet, wenn die über die Datenkanäle DE1 und DE2 abgegebenen Informationen I1 und I2 als 1-Signal ausgegeben werden.
Um wahlweise feststellen zu können, ob die beiden Datenkanäle DE2 und DE3 bzw. die Datenkanäle DE1 und DE3 ausgangsseitig auf 1-Signal liegen, sind weitere Reihenschaltungen gebildet aus den Lichtempfängern LE2 und LE6 bzw. den Lichtempfängern LE3 und LE4. Alle drei aus Lichtempfängern gebildeten UND-Glieder sind im Schaltungspunkt WO durch "Verdrahtetes ODER" zusammengeführt, so daß das Ausgaberelais RL immer dann angeschaltet wird, wenn mindestens zwei der drei Datenkanäle DE1, DE2 und DE3 ausgansseitig als Information 1-Signal führen.

Anstelle des Ausgaberelais RL kann ein beliebiger anderer elektrischer Verbraucher verwendet werden, beispielsweise eine der im Eisenbahnsicherungswesen üblichen Signallampen.

## Patentansprüche

1. Digitale 2 von 3-Auswahl- und Ausgabeschaltung mit sechs Optokopplern (OR1, OR2 bis OR6), bei welcher drei getrennte Datenkanäle unter zyklischer Vertauschung jeweils paarig drei UND-Gliedern aus je zwei Optokopplern zugeführt sind, denen eine gemeinsame ODER-Verknüpfung folgt als Ausgabeglied,
**dadurch gekennzeichnet,** daß die Lichtsender (LS1, LS4) jeweils zweier Optokoppler (OR1, OR4) in Reihe an je einen der Datenkanäle (DE1) angeschlossen sind und daß jeweils zwei Lichtempfänger (LE1, LE5) von Optokopplern (OR1, OR5), die sendeseitig verschiedenen Datenkanälen (DE1, DE2) zugeordnet sind, eine Reihenschaltung bilden und alle diese Reihenschaltungen auf die ODER-Verknüpfung (WO) geführt sind.

2. Schaltungsanordnung nach Anspruch 1, **dadurch gekennzeichnet,** daß die drei aus in Reihe geschalteten Lichtempfängern gebildeten Reihenschaltungen in einem Verdrahteten ODER (WO) zusammengefaßt sind und ein Ausgaberelais (RL) speisen.

## Claims

1. Digital 2-from-3 selector and output circuit with six optocouplers (OR1, OR2 to OR6), in which three separate data channels are supplied in each case in pairs, with cyclical exchange, to three AND-elements from in each case two optocouplers, which are followed by a common OR-linking as output element,
characterized in that the light transmitters (LS1, LS4) of the two optocouplers (OR1, OR4) respectively are connected in series to one of the data channels (DE1) respectively and in that in each case two light receivers (LE1, LE5) of optocouplers (OR1, OR5), which are associated on the transmitting side with various data channels (DE1, DE2), form a series connection and all of these series connections are guided on to the OR-linking (WO).

2. Circuit arrangement according to claim 1, characterized in that the series connections formed from light receivers connected in series are combined into a wired OR (WO) and feed an output relay (RL).

## Revendications

1. Circuit numérique de sélection et de sortie 2 parmi 3 comportant six optocoupleurs (OR1, OR2 à OR6) dans lequel trois canaux séparés de données sont envoyés respectivement par couples, moyennant une permutation cyclique, à partir de respectivement deux optocoupleurs, à trois circuits ET, en aval desquels est branché un circuit combinatoire OU commun constituant un circuit de sortie,
caractérisé en ce que les émetteurs de lumière (LS1,LS4) de respectivement deux optocoupleurs (OR1,OR4) sont raccordés en série à l'un respectif des canaux de données (DE1) et que respectivement deux récepteurs de lumière (LE1,LE5) d'optocoupleurs (OR1,OR5), qui sont associés, côté émission, à différents canaux de données (DE1,DE2), forment un circuit série et que tous ces circuits série sont raccordés au circuit combinatoire OU (WO).

2. Montage suivant la revendication 1, caractérisé par le fait que les trois circuits série formés par des récepteurs de lumière branchés en série sont réunis selon un circuit OU (WO) et alimentent un relais de sortie (RL)
